Europäisches Patentamt

European Patent Office

Office européen des brevets

(11) Publication number: **0 415 206 A2**

# EUROPEAN PATENT APPLICATION

(21) Application number: 90115798.2

(22) Date of filing: 17.08.90

(51) Int. Cl.5: **C23C 14/14**, C23C 14/56, B21C 37/02, C22C 1/00

(30) Priority: 31.08.89 JP 223083/89
25.07.90 JP 194853/90

(43) Date of publication of application:
06.03.91 Bulletin 91/10

(84) Designated Contracting States:
DE FR GB

(71) Applicant: YOSHIDA KOGYO K.K.
No. 1 Kanda Izumi-cho Chiyoda-ku
Tokyo(JP)

(72) Inventor: Yamagata, Hiroshi
1008, Dogenji, Tateyama-machi
Nakaniikawa-gun, Toyama(JP)
Inventor: Nagahora, Junichi
14-6, Sumiyoshidai, Midori-ku
Yokohama-shi, Kanagawa(JP)

(74) Representative: Patentanwälte Leinweber &
Zimmermann
Rosental 7/II Aufg.
W-8000 München 2(DE)

(54) Production method of metal foil and metal foil produced by the method.

(57) The present invention provides a production method of a metal foil comprising the steps of: depositing component particles from a deposition source material consisting of predetermined metal components in a vapor phase onto a substrate disposed to face the deposition source material and having an inert surface moving continuously, by a physical vapor phase deposition method in vacuum or in an inert gas atmosphere so as to form sequentially a thin film having a predetermined film thickness; and peeling off the thin film from the substrate surface to obtain a metal foil. The metal foils thus obtained may be in the state of an amorphous phase, a crystalline phase or a composite thereof by adjusting the gas pressure inside the apparatus, the distance between the substrate surface and the deposition source material, etc. Particularly, metal foils having at least 50 vol.% of an amorphous phase or a surface roughness (Rmax) not greater than 0.2 $\mu$m are very useful for various industrial applications because of their superior properties.

EP 0 415 206 A2

# PRODUCTION METHOD OF METAL FOIL AND METAL FOIL PRODUCED BY THE METHOD

## BACKGROUND OF THE INVENTION

### 1. Filed of the Invention

This invention relates to a production method of a metal foil used for a laminate material for foodstuffs, for decoration, for construction or for electromagnetic shield. This invention is also directed to a metal foil obtained by the production method.

### 2. Description of the Prior Art

As metal foils as above mentioned, there have heretofore been known metal foils having various thicknesses ranging from less than 10 $\mu$m to more than 10 $\mu$m and such metal foils have been usually produced by rolling several times a metal thin ribbon or sheet and reducing gradually the thickness of the thin ribbon or sheet.

In the production method of the metal foil described above, however, rolling must be carried out a plurality of times. Further, a lubricating oil must be used between a material to be rolled and rollers during the rolling process, and the surface of the metal foil does not become clean because impurities in air adhere to the surface of the rolled material during rolling. When an amorphous foil is produced, the limitation to the thickness, width and length of the thin ribbon occurs during its production process and for this reason, the dimensional limitation occurs in the production of the foil, too.

Generally, metal foils having a thickness of 10 $\mu$m or more have been produced by rolling several times and thinner metal foils of 10 $\mu$m or less in thickness have been produced from the rolled metal foils. In detail, the metal foils of more than 10 $\mu$m in thickness are stacked and then rolled to a desired thickness. However, in such a production process, it is necessary to separate the rolled stacked metal foils from each other at the final step and this separation step results in an unfavorably large surface roughness in the resulting metal foil.

## SUMMARY OF THE INVENTION

The present invention is therefore directed to provide a production method of a metal foil which solves these problems, can form a clean foil surface, and reduces the dimensional limitation when producing an amorphous foil.

Another object of this invention is to provide a metal foil of 10 $\mu$m or less in thickness in which the surface roughness expressed in terms of the maximum height (Rmax) is greatly reduced.

The present invention provides a production method of a metal foil comprising the steps of: depositing component particles from a deposition source material consisting of predetermined metal components in a vapor phase within the range of from one of the ends to the other of a substrate disposed to face the deposition source material and having an inert surface moving continuously, by a physical vapor phase deposition method in vacuum or in an inert gas atmosphere so as to form sequentially a thin film having a predetermined film thickness; and peeling off the thin film from the substrate surface to obtain a metal foil.

The present invention further provides a metal foil produced by depositing component particles from a deposition source material consisting of predetermined metal components onto a substrate disposed to face the deposition source material by a physical vapor phase deposition method in vacuum or in an inert gas atmosphere so as to form sequentially a thin film having a predetermined film thickness and then peeling off the thin film from the substrate surface to obtain the metal foil in which the maximum height (Rmax) of the surface roughness of both faces of the metal foil is not greater than 0.2 $\mu$m.

In this specification, "surface roughness" is designated by "maximum height (Rmax)" specified in Japanese Industrial Standard (JIS) B 0601 and is expressed as "surface roughness (Rmax)".

## BRIEF DESCRIPTION OF THE DRAWINGS

FIG. 1 is an explanatory view of Example 1 of the present invention;
FIG. 2 is a partial plan view of FIG. 1;
FIG. 3 is an explanatory view of Example 2;
FIG. 4 is an explanatory view of Example 3; and
Fig. 5 is a partial side view of FIG. 4.

## DETAILED DESCRIPTION OF THE PREFERRED EMBODIMENTS

The physical vapor phase deposition method described above includes sputter deposition, vacuum deposition, ion plating, etc., and the sputter deposition includes 2-electrode sputtering, 3-electrode sputtering, 4-electrode sputtering, magnetron sputtering, opposed target type sputtering, ion beam sputtering and dual ion beam sputtering. Furthermore, the former five sputtering methods can be classified into a D.C. application type and a high frequency application system. The present invention can be applied to any of these methods.

Sputter deposition is the method which causes the ion source, which is generated by an ion gun or plasma, to impinge against a target having the same composition as a thin film material to be formed, and deposits the atomic, molecular or cluster-like neutral particles or ion particles generated from the target due to the impingement onto a substrate.

Deposition source materials include Mg-Ni-Y, Al-Ti-Y, La-Ni-Al, Al-Ni-Y-N, and the like.

Next, the present invention will be explained definitely about the case where it is practiced by use of magnetron plasma sputtering.

An electrode (+ electrode) and a target (- electrode) made of a predetermined metal component are disposed to oppose each other inside a container kept at a sputter gas pressure of at least $1 \times 10^{-3}$ mbar and a voltage is applied between these electrodes so as to generate a plasma between them. A thin film is formed by disposing a substrate inside or near this plasma region. Since thin film formation means such as described above is used, the particles from the deposition source material are in the state of ions, atoms, molecules and clusters. Therefore, they are likely to be cooled between the deposition source material and the substrate surface and even though the particles are those which are difficultly converted to the amorphous state by a known liquid quenching method, they are converted to the amorphous state. A metal foil having a desired film thickness can be produced by adjusting power to be applied between the electrodes or the speed of the moving substrate.

In the method described above, a metal foil consisting of an amorphous phase, a metal foil consisting of a composite of an amorphous phase and a crystalline phase and a metal foil consisting of a crystalline phase can be selectively produced by adjusting the gas pressure inside the apparatus, the distance between the substrate surface and the deposition source material, and so forth. For example, a high cooling rate can be obtained for the particles of the deposition source material by reducing the gas pressure inside the apparatus and setting the distance between the substrate surface and the target within a predetermined range, and a metal foil consisting of an amorphous phase and a metal foil consisting of a composite of an amorphous phase and a crystalline phase can be produced. If the gas pressure is elevated inside the apparatus and the distance between the substrate surface and the deposition source material is set outside the range described above, on the contrary, the cooling rate of the particles of the deposition source material becomes low and a metal foil consisting of a crystalline phase can be produced.

Incidentally, when the invention is practiced by sputtering, for example, a metal foil consisting of a composite having an amorphous phase can be produced by setting the distance between the substrate surface and the deposition source material within the range of from 40 to 100 mm and adjusting the gas pressure inside the apparatus within the range of $1 \times 10^{-3}$ to $20 \times 10^{-3}$ mbar. A metal foil consisting of a crystalline phase can be produced if the distance between the substrate surface and the deposition source material is outside the range described above or if the gas pressure inside the apparatus is beyond $20 \times 10^{-3}$ mbar. If the gas pressure inside the apparatus is below $1 \times 10^{-3}$ mbar, uniform discharge cannot be maintained easily between the electrodes and a metal foil cannot be produced.

In the method described above, a metal material, a resin material, glass, and the like, can be used as the substrate. The term "inert substrate surface" used herein means the surface which has a low adhesion and from which the metal foil can be peeled off easily.

The term "deposition source material" used in the present invention means the target in the case of sputter deposition and the evaporation source in the case of ion plating and vacuum deposition.

The particles of the deposition source material consisting of the predetermined metal component in the form of ions, atoms, molecules and clusters are sequentially deposited onto the substrate surface moving continuously from one of the ends to the other of the deposition source material and a desired film thickness is obtained at the other end of the deposition source material. Thereafter, the substrate and the thin film are separated from each other so as to produce the metal foil. Here, the following means can be used as the separation means between the substrate and the thin film. For example, the other end of the deposition source material after passage is peeled off by a take-up roller at an angle different from the traveling direction of the substrate so as to take up the metal foil on the take-up roller. Alternatively, while the metal foil attaches to the substrate, it is taken up by the roller on the other side and the substrate and the metal foil are separated, whenever necessary, to produce the metal foil. Still alternatively, the substrate and the metal foil are separated by means such as a scraper.

The production method as set forth above is especially suitable to obtain a novel metal foil having a thickness of 2 to 10 $\mu$m and a surface roughness (Rmax) of not greater than 0.2 $\mu$m. When the foil thickness is less than 2 $\mu$m, the resultant metal foil can not be successfully peeled from a substrate. On the other hand, in the production of metal foils of greater than 10 $\mu$m in thickness, it is more economic to employ a rolling process rather than by the physical vapor deposition process of the present invention, although the process of the present invention can be also provide such relatively thick metal foils.

Hereinafter, embodiments of the present invention will be explained definitely with reference to the drawings.

Example 1

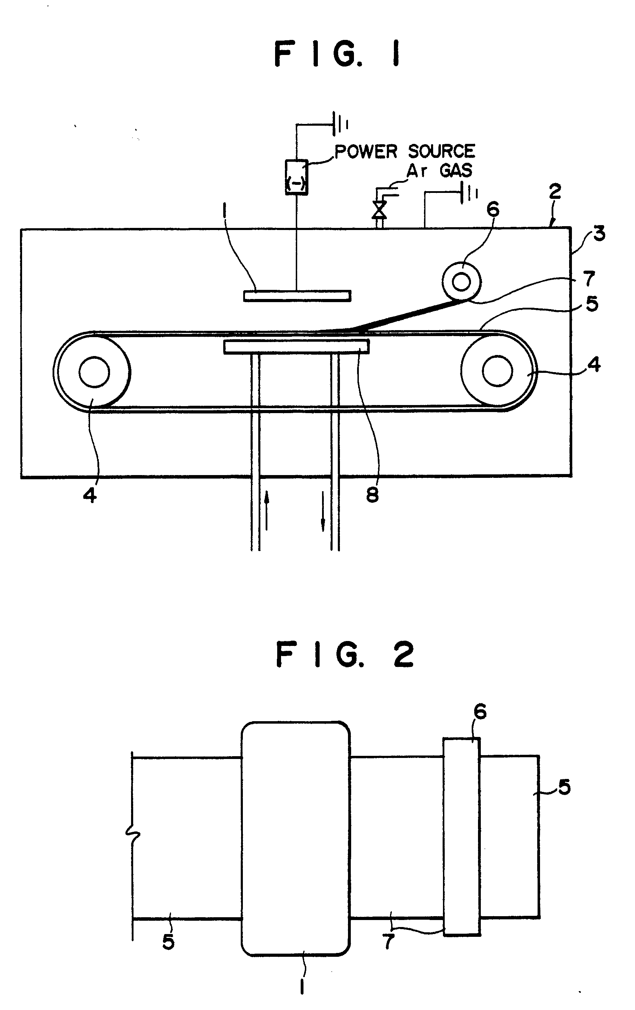

FIGS. 1 and 2 are schematic views showing an example of the apparatus suitable for practicing the present invention.

As shown in FIG. 1, a target 1 produced by a melting furnace and having a composition of predetermined components is disposed inside a sputter deposition apparatus 2 and a pair of guide rollers 4 are disposed between an electrode 3 (a ground electrode such as a vacuum container) and the target 1 with a predetermined gap. A substrate 5 which is an endless belt made of a soft metal material or resin material is disposed on the rollers 4. A take-up roller 6 is disposed above the substrate 5 in such a manner as to take up and guide the resulting metal foil 7 at an angle different from the traveling direction of the substrate 5. Whenever necessary, a cooling portion 8 for cooling the substrate surface is disposed near and below the substrate 5 onto which the particles of the target 1 are deposited. Here, after the inside of the sputter deposition apparatus 2 is evacuated by a vacuum pump (not shown), an argon gas is supplied into the apparatus and the internal pressure of the apparatus is kept constant in the interlocking arrangement with the vacuum pump. A voltage is applied under this state to the target 1 and, at the same time, the guide rollers 4, 4 are operated so as to move continuously the substrate 5 in the endless belt form. Sputter deposition is made onto the surface of the substrate 5 and the metal foil 7 is formed on the surface of the substrate 5. The metal foil 7 thus formed is taken up by the take-up roller 6. Incidentally, as shown in FIG. 2, the metal foil 7 produced comes to possess a uniform thickness by making the width of the substrate 5 to be smaller than the width of the target 1.

Example 2

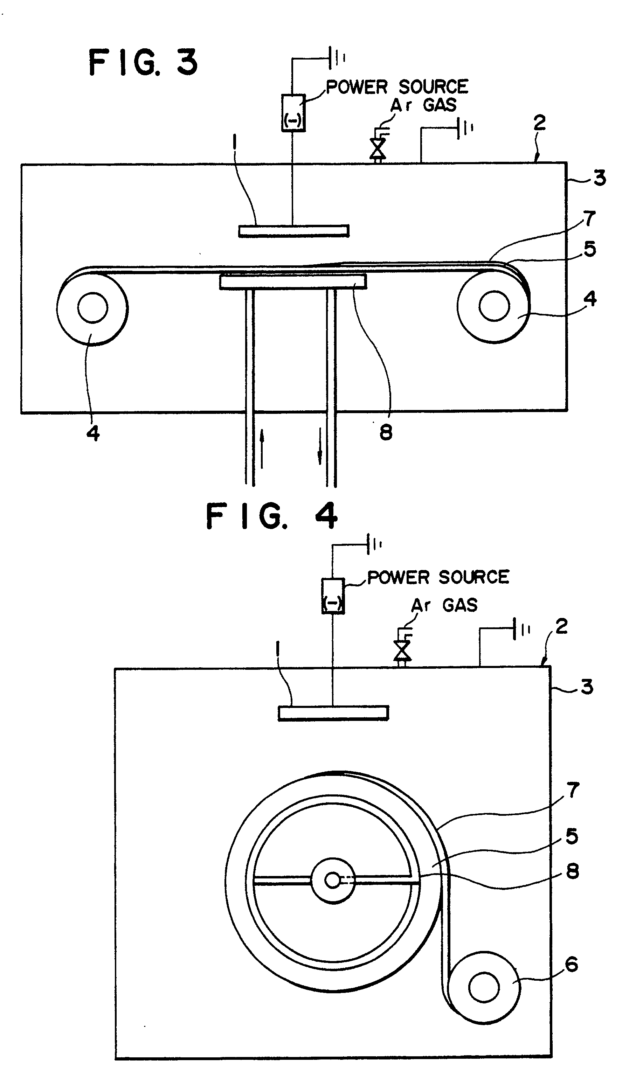

As shown in FIG. 3, the substrate 5 wound on the guide roller 4 on one of the sides (for example, on the left side) is sequentially supplied to the guide roller 4 on the other side (for example, on the right side). During this process, the metal foil 7 is formed on the substrate 5 by sputter deposition, and while the metal foil 7 adheres to the substrate 5, they are taken up on the guide roller 4 on the other side. The metal foil 7 and the substrate 5 on this guide roller 4 are separated from each other by the next step (not shown in the drawing). The rest are the same as in Example 1.

Example 3

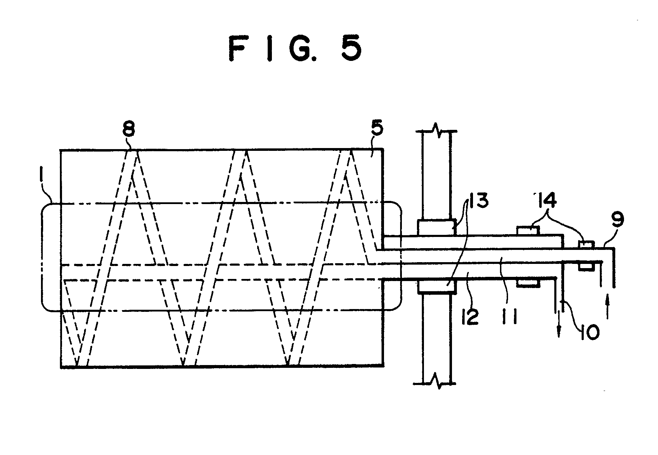

As shown in FIGS. 4 and 5, the substrate 5 is cylindrical and the cooling portion 8 is disposed on the inner peripheral surface of the substrate 5, whenever necessary, so as to deposit the particles of the target 1 onto the cylindrical outer peripheral surface of the substrate 5. The rest are the same as in Example 1. Here, a feed port 9 and a discharge port 10 of a cooling medium to and from the cooling portion 8 are stationary, and the feed portion 11, the discharge portion 12, the cooling portion 8 and the substrate 5 can rotate. In order to keep the gas pressure inside the apparatus at a constant pressure, an apparatus seal portion 13 is equipped with seal around the outer periphery of the discharge portion 12, and seal portions 14 are disposed so as to prevent the leakage of the cooling medium from between the feed port 9 and the discharge port 10 (fixed portion) and between the feed portion 11 and the discharge portion 12 (movable portion). Incidentally, since the substrate 5 has the shape described above, it is possible to use a rigid metal material, a rigid resin material, glass, and the like, as the material of the substrate.

According to the above Examples 1 to 3, there can be obtained multilayer metal foils by disposing plural targets made of different materials with a predetermined spacing between the targets. In this case, it is possible to form a metal foil consisting of various layers, such as decorative layer, corrosion-resistant layer, expensive layer, etc., by appropriately selecting the target material according the intended use.

Example 4

In accordance with the following procedure, a titanium foil was formed onto a cylindrical glass substrate using a titanium target in the magnetron sputter deposition apparatus, as shown in FIGS. 4 and 5. The width of the target was 8 cm and sputter deposition was conducted on the glass substrate disposed so as to oppose the target at a distance of 50 mm.

The substrate was cleaned and the inside of the apparatus was evacuated to a pressure of $2 \times 10^{-5}$ mbar or less and, then, an argon gas was introduced into the apparatus. While keeping the pressure within the apparatus at $3 \times 10^{-3}$ mbar, presputtering as a pretreatment was carried out for a period of 10 minutes using a shutter.

Thereafter, an electric power of 520 V x 0.04 A/cm² was applied to the target to form a film onto the substrate by sputter deposition of titanium. During the sputter deposition, the outer peripheral surface of the cylindrical glass substrate was moved at a rate of 0.8 cm/min. The film formed on the substrate was removed by a take-up roller or a scraper. In such a procedure, a 5 μm thick titanium foil was obtained. The titanium foil had a surface roughness (Rmax) of not greater than 0.1 μm both on the deposition face and the sides of the substrate.

Although metal foils can be also produced in the same manner as described above, using the apparatuses as shown in FIGS. 1 to 3, the substrate used in these apparatuses should be made of resin or metal. When a resin substrate is employed, the surface roughness (Rmax) of the substrate is large as compared with that of a glass substrate. However, the maximum surface roughness (Rmax) of usually used resin substrates such as plastic sheets is about 0.2 μm and metal foils having a surface roughness (Rmax) of 0.2 μm or less can be easily obtained. Therefore, there is no problem in practical applications. Further, the surface roughness (Rmax) of the resin or metal substrate can be reduced by an appropriate treatment and, thereby, the surface roughness (Rmax) of the metal foil formed on the substrate can be also reduced.

As described above, the present invention produces the metal foil by the thin film formation means by the physical vapor phase deposition method. Therefore, the production of the metal foil can be made by one step or two steps and can be made easily. The present method can obtain a multi-layered metal foil consisting of a plurality of layers having mutually different compositions and since the production is carried out in vacuum or in the inert gas atmosphere without requiring rolling of the surface by the rollers, a metal foil having a clean surface can be obtained. Furthermore, when the amorphous metal foil is produced, the dimensional limitation becomes smaller because it depends only on the quantity of the deposition source material. Since the metal foils are produced by the thin film formation means described above, amorphous alloys, which can be hardly obtained by the ordinary single roller method or the like, can be produced. When the metal foil which is at least 50% amorphous is produced by the method described above, the resulting metal foil has the excellent properties inherent to the amorphous alloy such as high hardness, high strength and high corrosion resistance, and is therefore very useful for various industrial applications. Particularly, since the metal foils having a surface roughness (Rmax) of 0.2 μm or less have very flat faces, they will produce a high degree of decorative effect in use for structural materials, etc. and are also useful as conductive materials or the like.

## Claims

1. A production method of a metal foil comprising the steps of:
depositing component particles from a deposition source material consisting of predetermined metal components within the range of from one of the ends to the other of a substrate disposed to face said deposition source material and having an inert surface moving continuously, by a physical vapor phase deposition method in vacuum or in an inert gas atmosphere so as to form sequentially a thin film having a predetermined film thickness; and peeling off said thin film from said substrate surface to obtain said metal foil.

2. A production method of a metal foil according to claim 1, wherein said deposition source material is disposed at a predetermined distance from said substrate surface, and said metal foil consists of a composite having at least 50% (vol%) of an amorphous phase.

3. A metal foil produced by depositing component particles from a deposition source material consisting of predetermined metal components onto a substrate disposed to face said deposition source material by a physical vapor phase deposition method in vacuum or in an inert gas atmosphere so as to form sequentially a thin film having a predetermined film thickness and then peeling off said thin film from said substrate surface to obtain said metal foil, the maximum height (Rmax) of the surface roughness of both faces of said metal foil being not greater than 0.2 μm.

4. A metal foil according to Claim 3, wherein the thickness of said metal foil is from 2 to 10 μm.

# F I G. 1

POWER SOURCE

Ar GAS

# F I G. 2

# FIG. 3

POWER SOURCE

Ar GAS

(-)

2

3

1

7

5

4

4

8

# FIG. 4

POWER SOURCE

Ar GAS

(-)

2

3

1

7

5

8

6

# F I G. 5